Europäisches Patentamt

European Patent Office

Office européen des brevets

(19)

(11) **EP 1 367 402 A1**

(12) **EUROPEAN PATENT APPLICATION**

(43) Date of publication:
**03.12.2003 Bulletin 2003/49**

(51) Int Cl.7: **G01R 25/00**, G01R 25/02,
G01R 31/28

(21) Application number: **02077183.8**

(22) Date of filing: **02.06.2002**

(84) Designated Contracting States:
**AT BE CH CY DE DK ES FI FR GB GR IE IT LI LU
MC NL PT SE TR**
Designated Extension States:
**AL LT LV MK RO SI**

(71) Applicant: **Agilent Technologies, Inc. - a Delaware
corporation -
Palo Alto, CA 94303-0870 (US)**

(72) Inventor: **Verspecht, Jan
1840 Steenhuffel (BE)**

(74) Representative: **Coker, David Graeme
Agilent Technologies UK Ltd,
Legal Dept,
Eskdale Road,
Winnersh Triangle
Wokingham, Berks RG41 5DZ (GB)**

(54) **Method and arrangement for phase measurement of a modulated RF signal**

(57) A method is disclosed and demonstrated that allows the accurate characterization of the phase error of a modulated RF signal of a device-under-test (DUT), such as a Vector Signal Analyzer (2). The method not only eliminates the need to have accurate knowledge on the test signal (1) that is used, but also that it elimi-
nates the need to accurately know the transfer function of the receiver (3, 4) which is used to characterize the signal. The principle is based on the typical characteristics of a homodyne mixing receiver (3, 4). The theoretical concept is explained and is illustrated by actual measurements and an arrangement for performing the method.

Fig. 13

EP 1 367 402 A1

**Description**

Background of the Invention

The present invention relates generally to Radio Frequency (RF) and microwave technology, and more specifically to accurate phase measurement of a modulated RF signal. The method also applies to phase error or phase distortion measurement of a "Vector Signal Analyzer" (VSA).

Field of the Invention

The future of wireless industry (the so-called 3G technology) relies on the successful realization of analog electronic circuits which can handle broadband complex modulation formats. For these and other RF signals and circuits there is a need for an accurate characterisation of the performance of such signals and circuits.

The classical approach to measure the phase of a modulated signal is to use a heterodyne mixer followed by a digitizer. However, a phase error will be present using this method.

In a prior art solution, a broadband heterodyne mixing process is used, assuming a reciprocal mixer. Reference is made to "Network Analyzer Measurement of Frequency-translating Devices", by C.J. Clark, et al., Microwave Journal, November 1996, p. 114-126.

In a further prior art method use is made of a modulated RF signal, the amplitude of which is characterised versus time. This method is based on the assumption that an RF test signal free of parasitic phase modulation is used, and which is purely modulated in amplitude. Reference is made to "Calibrated Linear and NonLinear pulsed RF measurements on an amplifier", by Philip Vael, et al., 0-7803-6540-2/01/$10.00 (C) 2001 IEEE.

Those skilled in the art will appreciate that the accuracy of the above prior art methods essentially depend on the validity of the assumptions made, i.e. "mixer reciprocity" and the absence of phase modulation which, in practice, is hardly to achieve.

The characterization of complex modulated signals is usually performed by a commercial Vector Signal Analyzer (VSA). This instrument can measure the amount of amplitude as well as phase modulation, or equivalently the in-phase (I) and quadrature-phase (Q) components, of a complex modulated signal. The accurate determination of the phase error (also called phase distortion) of a VSA is a non-trivial task.

Summary of the Invention

It is an object of the present invention to provide a method for accurate phase measurement of RF modulated signals completely eliminating Intermediate Frequency (IF) distortion of a mixer used for characterising the modulated signal.

It is a further object of the present invention to provide a method for accurately characterising the phase error or phase distortion of a VSA.

These and other objects are solved, according to the present invention, by a method for accurately characterizing the phase error of an RF signal using a homodyne mixing process as an intermediate measurement step.

The present invention is based on the insight that the phase error of a homodyne mixer can be completely eliminated, resulting in a distortion free measurement of the phase characterisation of an RF signal or the phase error of a VSA.

The present invention not only eliminates the need for accurate knowledge of test signals to be used, but also eliminates the need to accurately know the transfer function of a broadband receiver used to characterize the signal.

In accordance with the present invention for measuring the phase characteristic of a modulated RF signal of a device-under-test, the method comprises the steps of:

subjecting the RF signal to a homodyne mixing process by applying a test signal having a predetermined frequency spectrum providing an IF output signal having first and second signal parts,
measuring frequency spectra of the test signal and the first and second IF output signal parts at a plurality of discrete frequencies, and
calculating the phase characteristics of the RF signal from the measured frequency spectra.

The invention further relates to an arrangement for performing the above method and embodiments thereof as disclosed in the attached claims.

The above-mentioned and other features and advantages of the invention are illustrated in the following detailed description with reference to the enclosed drawings.

Brief Description of the Drawings

Fig. 1 is a schematic graphic representation of a typical test spectrum generated by a test signal generator for use with the method according to the present invention for measuring the phase error of a VSA as a device-under-test (DUT).

Fig. 2 shows a schematic graphic representation of negative and positive frequency parts of the test spectrum measured by a homodyne receiver connected to the VSA under test, in accordance with the present invention.

Fig. 3 shows a schematic graphic illustration of the test spectrum as seen on the display of the VSA.

Figs. 4-12 show plots of measured and calculated data in accordance with the method of the present invention, obtained for the VSA under test.

Fig. 13 shows a block diagram of a typical measurement set-up for measuring the phase error of the VSA under test according to the present invention.

Detailed Description of the Embodiments

Without any limitation, the invention will now be explained in more detail with reference to the determination of the phase error of a VSA. However, the theoretical concept explained is likewise applicable to accurate phase characterisation of a modulated RF signal of a device-under-test.

Suppose that one wants to determine the phase error (or the associated group delay error) of a particular VSA with a "single-side" bandwidth noted $b$. This implies that the VSA can measure the spectral contents of a complex modulated signal from a frequency $f_c$-$b$ to $f_c$+$b$, where $f_c$ corresponds to the "carrier frequency" setting of the VSA ($f_c$ can typically vary across a wide band, from a couple of MHz to several GHz).

It is assumed in the following that the phase error of the VSA is independent from $f_c$, and is only depending on the frequency $f_v$ which is defined relative to $f_c$. This is a safe assumption since the radio-frequency (RF) front-end is very broadband, which implies a negligible deviation from linearity for the phase across a bandwidth of two times $b$. Note that the relative frequency $f_v$ is the one that is typically used on the VSA output screen and markers. The phase error will as such only be a function of $f_v$. This error is mainly caused by the non-ideal intermediate frequency (IF) filters and analog-to-digital convertor.

In the remainder there will be used a scaled frequency variable f, which equals $f_v$ divided by $b$. The problem to be solved is as such defined as the measurement of the phase error, noted E(f), on the interval (-1, +1).

Next one uses a synthesizer or signal generator and generates a complex spectrum S(f) with a carrier frequency setting on the synthesizer equal to $f_0$, where S(f) is different from zero for ‖f‖≦1-$a$, with $a$ being an arbitrary parameter. Note that, for the definition of S(f), f is scaled by $b$, but is defined relative to $f_0$ in stead of $f_c$. The parameter $a$ represents the fraction of the VSA bandwidth which will not be covered by measuring S(f), assuming that $f_c$, the carrier frequency setting of the VSA, equals $f_0$, the carrier frequency setting of the synthesizer. As will be clarified later, it is recommended to choose $a$ larger than 1/3 but smaller then 2/3.

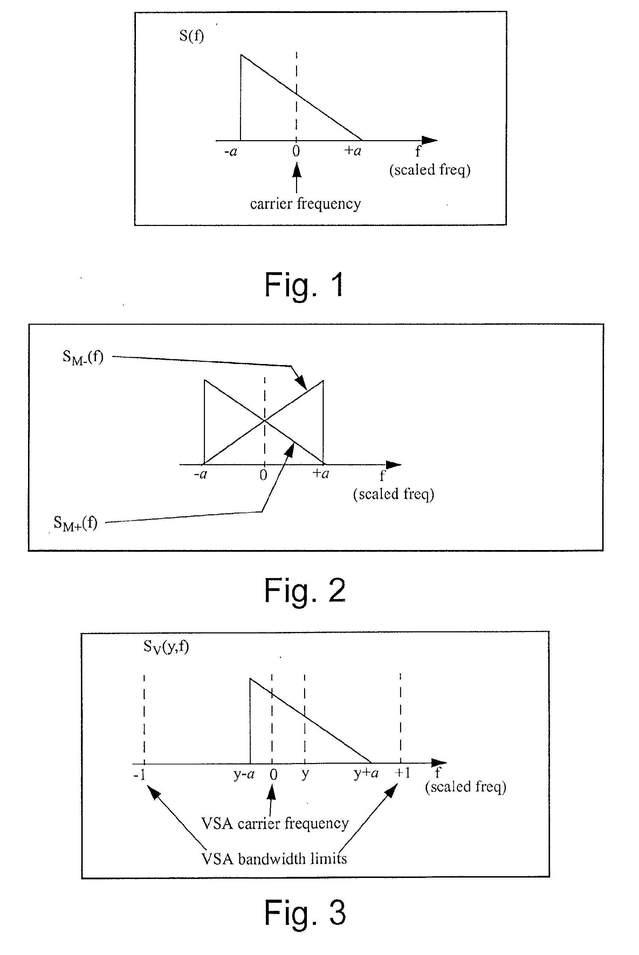

Next one performs an intermediate measurement of S(f) by using a homodyne receiver. This is done as follows. The spectrum S(f) is frequency converted by a broadband sampling mixer such that the carrier frequency $f_0$ is mapped to a zero frequency (DC). The output of this mixing process is digitized. This kind of frequency conversion, called homodyne mixing, implies that the part of S(f) corresponding to negative frequencies (f < 0) as well l as the part of S(f) corresponding to positive frequencies (f > 0) are mapped into the frequency interval (0, 1-$a$). The resulting down converted positive frequency part of S(f) will be called $S_{M+}$(f) and the resulting down converted negative frequency part will be called $S_{M-}$(f). The definitions of the different spectra S(f), $S_{M+}$(f) and $S_{M-}$(f) are illustrated in Fig. 1 and Fig. 2. From Figs. 1 and 2 one can write:

$$S_{M+}(f) - S(f)\ T_M(f)\ \exp(-jq_M) \qquad (1)$$

$$S_{M-}(f)\ S^*(-f)\ T_M(f)\ \exp(jq_M) \qquad (2)$$

In the above equations $T_M$(f) represents the IF distortion characteristic of the homodyne receiver and $q_M$ represents the unknown and arbitrary phase difference between the synthesizer carrier and the local oscillator used for the mixer of the homodyne receiver. The symbol "*" denotes the complex conjugate.

In what follows will be explained how the phase characteristic of the VSA can be retrieved by eliminating S(f) as well as $T_M$(f). In order to achieve this one actually measures $S_{M+}$(f) as well as $S_{M-}$ (f). How this is done in practice is explained later in the description.

Next the frequency $f_c$ is stepped upwards from $f_0$-*ab* to $f_0$+*ab*. At each VSA carrier frequency step a VSA measurement of the spectrum of the test signal S(f) is performed. This measurement will be noted $S_V$(y,f), with parameter y being defined as $f_0$-$f_c$ divided by *b*. $S_V$(y,f) is illustrated in Fig. 3. One can then write:

$$S_V(y,f) = S(f-y) \, T_V(f) \, \exp(-jq_V) \tag{3}$$

In the above equation $T_V$(f) represents the unknown IF distortion characteristic of the VSA and $q_V$ represents the arbitrary phase difference between the synthesizer carrier and the local oscillator used inside the VSA, which is unknown and different for each VSA measurement.

Note that, in the context of this invention, the goal is not to determine $T_V$(f), but one is interested in the phase error E(f), which equals the phase of the complex valued function $T_V$(f).

From (3) the following equations (4) and (5) can be derived:

$$S_V(y,f+y) = S(f) \, T_V(f+y) \, \exp(-jqV) \tag{4}$$

$$S_V(y,-f+y) = S^*(-f) \, T^*_V(-f+y) \, \exp(-jqV) \tag{5}$$

Once $S_{M+}$(f), $S_{M-}$(f) and the two-dimensional function $S_V$(y,f) have been measured, the function M(y,f) can be defined, as written in (6).

$$M(y,f) = \text{Arg}[\{S_V(y,f+y)/S^*_V(y,-f+y)\} \, S_{M-} (f)/S_{M+}(f)] \tag{6}$$

Using (1), (2), (4), (5) together with (6) results in the following equation:

$$M(y,f) = \text{Arg}[\{S(f)T_V(f+y)\exp(-jq_V) \, S^*(-f)T_M(f)\exp(jq_M)\}/$$

$$\{S^*(-f)T^*_V(-f+y) \, \exp(jq_V) \, S(f)T_M(f)\exp(-jq_M)\}] \tag{7}$$

which can simply be written as:

$$M(y,f) = E(y+f) + E(y-f) + 2(q_M - q_V) \tag{8}$$

This provides the most important feature of the proposed method: the measured two-dimensional function M(y,f) is independent from the generated signal S(f) and is independent from $T_M$(f), the distortion characteristic of the homodyne receiver that was used to characterize the signal. The resulting function M(y,f) is only a function of the VSA phase error E(f) and the phase difference between the carrier of the synthesizer and the local oscillator of the VSA.

Next the function $M_0$(y,f) can be constructed as follows:

$$M_0(y,f) = M(y,f) - \lim_{f \to 0} M(y,f) \tag{9}$$

One can then write the following equation:

$$M_0(y,f) = E(y+f) + E(y-f) - 2E(y) \tag{10}$$

The resulting measured quantity $M_0(y,f)$ is now only a function of the quantity of interest $E(f)$.

All dependencies on $S(f)$, $T_M(f)$, $q_v$ and $q_M$ have been eliminated. As such the problem is reduced to the extraction of the unknown $E(f)$ based upon the knowledge of $M_0(y,f)$.

Note that $M_0(y,f)$ is known from measurements for $-a < y \leq a$ and for $-a-1 \leq f \leq 1-a$.

Before continuing with the construction of the algorithm to determine $E(f)$ from $M_0(y,f)$, first the functional operator which transforms the one-dimensional $E(f)$ into the two-dimensional $M_0(y,f)$ is investigated.

A first important characteristic of this operator is that the superposition theorem holds. This feature will be used later in order to derive important characteristics of the final solution $E(f)$.

A second important characteristic is the so-called null-space of the operator, noted $Z(f)$. In order to find this one has to solve the following functional equation. By the term "functional equation" is meant that one needs to solve this equation for $Z(.)$ and not for "y" or "f":

$$Z(y+f) + Z(y-f) - 2Z(y) = 0 \tag{11}$$

Rewriting (11) as:

$$Z(y) = \{Z(y-f) + Z(y+f)\}/2 \tag{12}$$

implies that a function belongs to the null-space if the value of the function at any given point "y" is the average of the function values at the edges of any interval symmetric around this point "y".

The only solution that satisfies this constraint is a straight line, which means that one can write the following:

$$Z(y) = r + sy \tag{13}$$

with $r$ and $s$ arbitrary constants.

An important consequence from the superposition theorem and from the existence of the null-space is that the knowledge of $M_0(y,f)$ does not allow the extraction of a unique $E(f)$, but implies that the addition of any arbitrary straight line to an existing solution is also a solution. This is not a limitation of the proposed method, however, since the only meaningful phase error of a VSA is actually its deviation from a straight line. Adding any constant phase shift and/or linear phase shift does not change the integrity of the modulation information which is returned by the VSA.

As such one should consider the whole family of functions $E(f) + rf + s$, with arbitrary $r$ and $s$ as equivalent representations of the VSA phase error.

Next it will be explained how $E(f)$ can be extracted out of the knowledge of $M_0(y,f)$. One can write (10) as follows:

$$E(y) = \{E(y+f) + E(y-f) - M_0(y,f)\}/2 \tag{14}$$

This equation is very similar to (12). It implies that the value of $E(y)$ can be extracted if the value of $M_0(y,f)$, $E(y+f)$ and $E(y-f)$ is known. Since a straight line can be added to $E(f)$, two values of $E(.)$ can be freely chosen. A convenient choice is to set $E(-a)=E(a)=0$. Then easily the value of $E(f)$ can be found in the middle of the interval $(-a, a)$ by applying (14) with y=0 and f=a. The result is the following:

$$E(0) = -M_0(0,a)/2 \tag{15}$$

The value of $E(f)$ is now found in the middle of the intervals $(-a, 0)$ and $(0, a)$.

Applying (14) once more results in the following two equations:

$$E(-a/2) = \{E(0) - M_0(-a/2, a/2)\}/2 \tag{16}$$

$$E(a/2) = \{E(0) - M_0(a/2, a/2)\}/2 \tag{17}$$

Applying the same technique one can find the value of E(.) in the middle of the intervals:
(-$a$,-$a$/2), (-$a$/2, 0), (0, $a$/2) and ($a$/2, $a$).

This process of finding E(.) in the middle of each of the intervals for which one already knows the value at the edges can be repeated recursively. At each step of the recursion the length of the interval is divided by 2. As such this procedure allows to calculate the value of E(.) arbitrarily close to any real number belonging to the interval (-$a$, $a$). Since E(f) is a continuous function, this implies that one can completely reconstruct E(f) on the interval (-$a$, $a$).

Next it will be shown how to construct the value of E(f) on the intervals (-1, -$a$) and ($a$, 1). Consider a frequency $f_0$ in the interval ($a$, 1). Writing (14) with $y$=$a$ and f=$f_0$-$a$ results in the following:

$$E(a) = \{E(f_0) + E(2a\text{-}f_0) - M_0(a,f_0\text{-}a)\}/2 \tag{18}$$

The above equation can be solved for E($f_0$):

$$E(f_0) = 2E(a) - E(2a\text{-}f_0) + M_0(a,f_0\text{-}a) \tag{19}$$

A similar procedure can be used to find the solution of E($f_0$) for $f_0$ belonging to the interval (-1, -$a$):

$$E(f_0) = 2E(\text{-}a) - E(\text{-}2a\text{-}f_0) + M_0(\text{-}a,\text{-}f_0\text{-}a) \tag{20}$$

As can be verified, the above three simple steps allow to calculate the value of E(f) on the interval (-1,+1), provided that:

$$1/3 \leq a \leq 2/3 \tag{21}$$

In the case that the condition (21) is not fulfilled, it is still possible to construct E(f) on the whole interval (-1, +1), but many more steps may be needed.

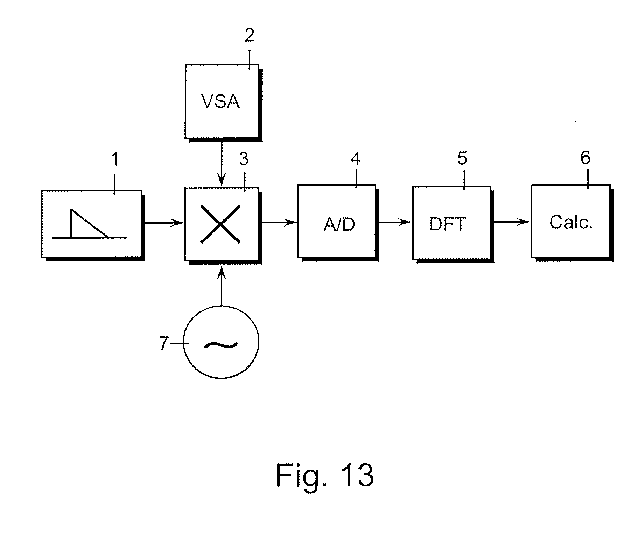

In an experimental setup, shown in Fig. 13, the following equipment is used in order to demonstrate this novel measurement technique. A signal generator 1 of the type Agilent E4433B ESG-D digital modulation synthesizer connects to an input of a homodyne receiver, which is build by using an Agilent 85120A K60 Sampling Convertor as a homodyne mixer 3 and an Agilent E1430 as analog-to-digital convertor 4. The device-under-test (DUT) is an Agilent E44O6A VSA Series Transmitter Tester 2. An output of the VSA 2 connects to another input of the homodyne mixer 3.

All instruments mentioned above are synchronized by using the 10 MHz reference clock of the VSA 2. For illustrating the method according to the invention the VSA 2 is used in an uncalibrated mode of operation.

The single-side bandwidth of the VSA 2 used is 7.5 MHz, the total bandwidth is 15 MHz. Note that 7.5 MHz corresponds as such to the normalization factor used to represent frequencies.

In order to be able to perform the measurements with good dynamic range, a signal is generated by the signal generator 1 with a discrete spectrum. The signal used contains 4376 equally spaced tones with a spacing $D_f$ of 1/16384th of 30 MHz, which approximately corresponds to 1831 Hz. This implies that the signal has a total bandwidth of approximately 8 MHz. The synthesizer carrier frequency is chosen such that the 2189th component (the first component of the upper half of the tones) is at a frequency of 1.98 GHz plus 1/4th of $D_f$.

The phase of the tones is chosen in order to make sure that the signal has a low peak-to-rms ratio (also called crest-factor). This is achieved by choosing a parabolic phase. Note that this kind of signal is also known as a "Schroeder multisine". The advantage of using such a signal is that one can apply more energy at each spectral component without causing nonlinear compression effects in the mixer.

This signal, corresponding to S(f), is then frequency converted close to DC by the homodyne mixer 3. This is an harmonic mixer with a local oscillator 7 of 20 MHz. The generated signal will as such be converted by the 99th harmonic of this local oscillator, which corresponds to a frequency of 1.98 GHz. The resulting IF signal is digitized by the high-performance 10 MHz sampling rate analog-to-digital convertor 4. A discrete Fourier transform is used in order to arrive at the measured values of the converted spectral components.

The first component of the upper half of the tones (from tone 2189 to tone 4376) will appear at the IF-output of the homodyne mixer 3 having an IF frequency equal to 1/4th of $D_f$ , the Nth component of the upper half of the tones (tone 2188 + N) will have an IF frequency at the IF output of the mixer 3 equal to (N+1/4) times $D_f$. The down converted spectrum of this upper half of the tone corresponds to $S_{M+}$(f).

Tone 2188, the last component of the lower half of the tones (from tone 1 to tone 2188) will have an IF-frequency equal to 3/4th of $D_f$. The Nth component of the lower half of the tones will have an IF frequency equal to (2188-N+3/4) times $D_f$. Note that the converted lower half of the tones correspond to $S_{M-}$ (f). The set of frequencies corresponding to $S_{M+}$(f) and $S_{M-}$(f) differ by an offset which equals $D_f$/2. This allows to measure both of them without any interference at the IF output of the mixer 3. Note that such interference would always be happening using a continuous in stead of a discrete spectrum.

This frequency offset does introduce the need to assume that the phase of the complex transfer function $T_M$ (f) does not significantly change across a $D_f$/2 interval. In other words one assumes that:

$$Arg\{T_M(f)\} \approx Arg\{T_M(f + \tfrac{1}{2}D_f)\} \tag{22}$$

In our case, ($b\ D_f$)/2, (the not normalized frequency difference) is approximately equal to 915 Hz relative to a total IF bandwidth of 4 MHz, having a relative ratio of approximately 4000.

Knowing that the IF part was designed to have a minimal phase distortion across the whole bandwidth, we can safely assume that the error caused by this small frequency offset is insignificant.

The above deals with the generation of S(f) and the measurement of $S_{M+}$(f) and $S_{M-}$(f). The following will deal with the actual VSA measurements which correspond to $S_v$(y, f).

A total of 381 VSA measurements are performed where each of the individual measurements is denoted by an index ranging from -190 to +190. The carrier frequency setting of the VSA for each measurement is different and equals 1.98 GHz + (3/4 - 10N)$D_f$, where N denotes the measurement index. This set of measurements corresponds to a scan in the variable y, where each measurement returns a different function of f. The result is a densely sampled version of the function $S_v$(y,f).

The value of the parameter $a$ for our measurements is (10·190)/(10·190+2188), which approximately equals 0.4648. The total set of measurements allows to calculate the functions M(y,f) and $M_0$(y, f), and allows as such to calculate E(f), the unknown phase error of the VSA.

Suitable processing and calculation means comprise Discrete Fourier Transform (DFT) means 5 and digital processing means 6 which may comprise a microprocessor or microcomputer. The means 5 and 6 may be combined into a single processing device.

Some figures are used in the following in order to illustrate and give more insight in the above.

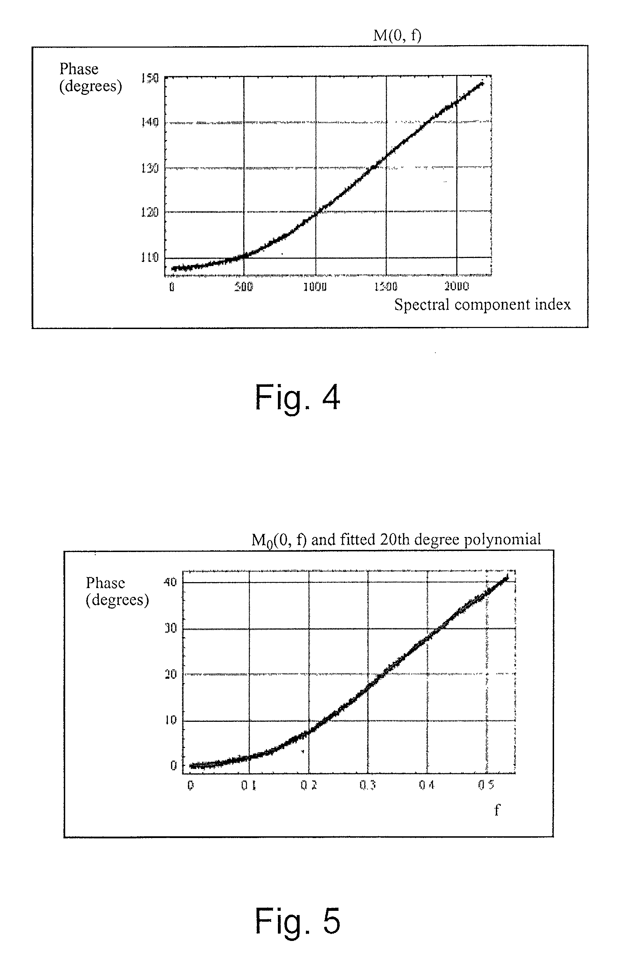

Fig. 4 shows the measured value of M(0,f) for all the relevant spectral components. The components are denoted by their spectral component index (from 1 to 2188).

Fig. 5 shows the measured value of $M_0$(0,f) together with a fitted polynomial. The fitting of a high degree polynomial is performed in order to calculate:

$$\lim_{f \to 0} M(y,f).$$

The fitted polynomial is also used to compress the data. The polynomial fit is performed for all 381 VSA measurements. It turned out that a 20th degree polynomial is sufficient in order to accurately fit all of the data.

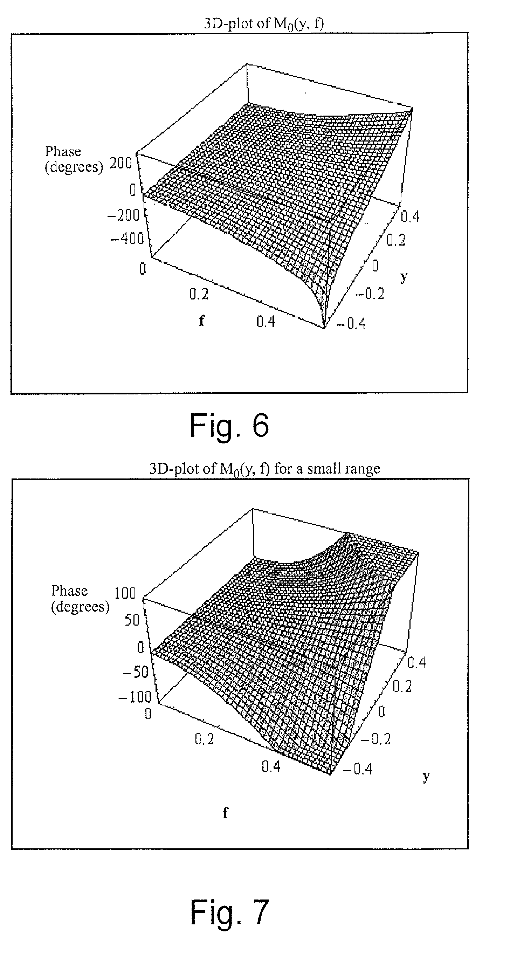

Fig. 6 and Fig. 7 show plots of the function Mo(y,f) for the whole range of "y" (from -$a$ to $a$). A simple linear interpolation of all polynomials (which are a function of "f") versus parameter "y" is used in order to estimate values of $M_0$(y,f) for "y"-values which are not exactly at the uniform "y"-grid. Next the values of E(f) on the interval (-$a$,+$a$) are derived by using the algorithm explained in (14) until (17).

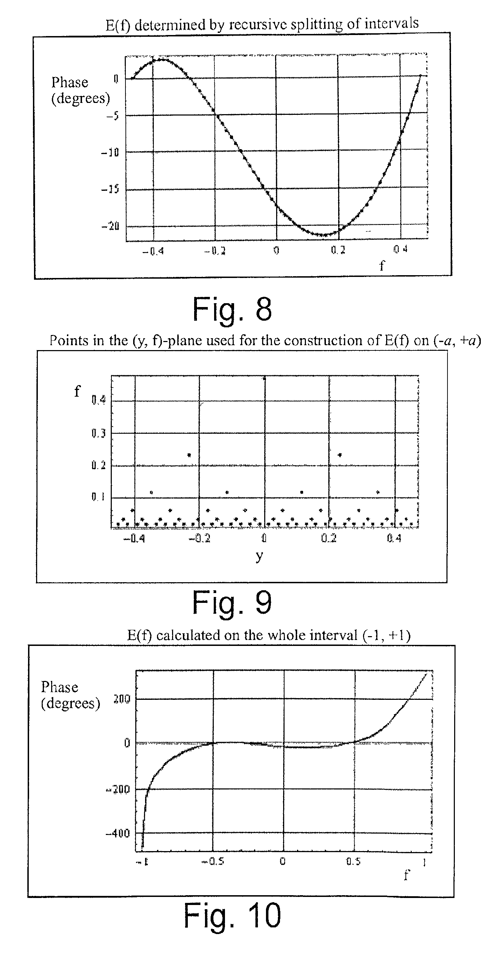

Repeating the procedure six times results in densely sampled values of E(f). The result, together with an interpolation, is shown in Fig. 8.

Fig. 9 represents the points in the (y, f)-plane that were used to derive these sampled values of E(f).

The values of E(f) on the interval (-1, -$a$) are found by applying (20), and the values of E(f) on the interval (+$a$, 1) are found by applying (19). The final result are the values of the function E(f) on the whole interval (-1, +1), which corresponds to the complete VSA bandwidth. Note that "f" should be multiplied by 7.5 MHz in order to retrieve a non normalized frequency axis.

The validity of the data are checked as follows. As can be derived from Fig. 9 only a very limited subset of the measured data is actually used in order to calculate E(f). One has the 63 points depicted in Fig. 9, which are used for calculating E(f) on the interval (-$a$, +$a$), one has the line represented by the equation y = -$a$ for the calculation of E (f) on the interval (-1, -$a$), and one has the line represented by the equation y = $a$ for the calculation of E(f) on the interval (+*a*,+1). The fact that only a fraction of the actual measured data is used implies that there is a lot of redundancy in the measured data. This is a very useful characteristic which allows to check the validity of the data as well as the validity of the assumptions that were made.

It is possible to make the difference between the measured $M_0(y,f)$ and the "expected $M_0(y,f)$" which is calculated by applying (10) on the calculated E(f).

The maximum difference between the two, for the present measurements and evaluated for the whole (y,f)-plane, which is depicted in Fig. 9, is about 2 degrees. This implies that all data are valid within this tolerance. As a consequence we expect the accuracy of our measurement to be in the order of a few degrees, and this for the whole bandwidth.

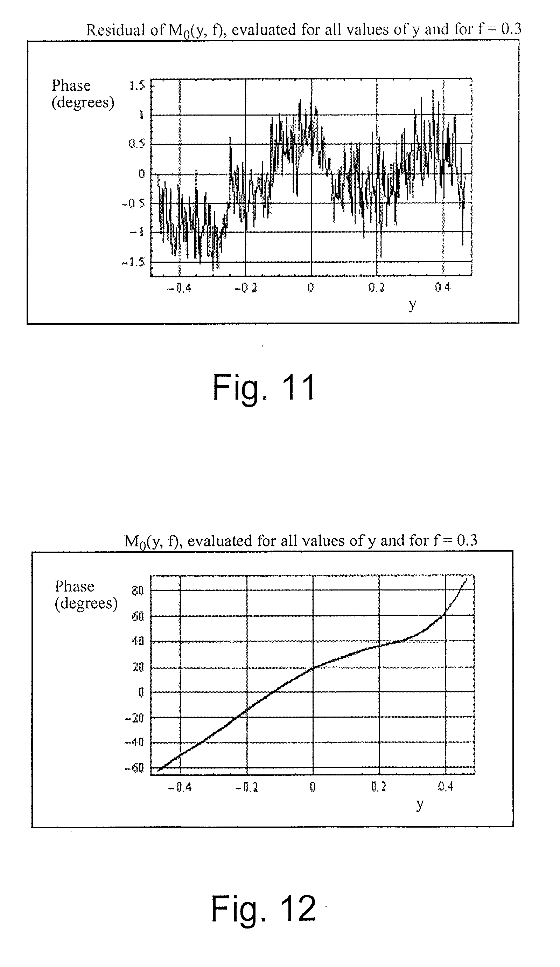

Fig. 11 illustrates the above specified residual, evaluated for all values of y and for f = 0.3. As can be seen in Fig. 9, only very few values close to the line obeying f = 0.3 were used in order to derive the value of E(f), so the result is a good measure of the validity of the data and the associated assumptions.

In order to get an idea of the relative value of this residual Fig. 12 represents $M_0(y,f)$ itself evaluated on the line obeying f = 0.3.

In the above we expressed data redundancy by first constructing E(f) out of a limited set of evaluations of the measured $M_0(y,f)$ and by finally comparing the "expected $M_0(y,f)$" with the actually measured $M_0(y,f)$, and this for the whole of the (y,f)-plane which is covered by the measurements.

Another and more efficient way to deal with this issue is based on the fact that (23) holds, purely based on the definition of $M_0(y, f)$. This can readily be verified using (10):

$$M_0(y,f) - M_0(y+\tfrac{1}{2}f,\tfrac{1}{2}f) - 2M_0(y,\tfrac{1}{2}f) - M_0(y-\tfrac{1}{2}f,\tfrac{1}{2}f) = 0 \qquad (23)$$

Inserting the measured $M_0(y,f)$ in (23) results in the calculation of a residual, without the need to calculate E(f). This calculation is performed on the measured data and results in a residual with a maximum deviation of 2 degrees, similar to the previously defined residual.

The robustness of the method can be verified as follows. Theoretically spoken, the measured $M_0(y,f)$ should only depend on E(f), and not on other things like S(f), $T_M(f)$, $q_v$ and $q_M$, ...

Several experimental results confirm this expected insensitivity of $M_0(0,f)$. A short overview is given in the following. Note that for all measurement parameter changes described below, the difference with the original measurement was smaller than the noise on the data (about 1 degree rms):

- the measurement has been repeated for all (four) channels of the sampling convertor, checking the insensitivity versus $T_M(f)$
- the RF carrier frequency $f_0$ was changed drastically, going from 500 MHz up to 4 GHz, verifying the insensitivity versus $f_0$ (and probably also S(f))
- the local oscillator frequency of the sampling convertor was changed from 20 MHz to 10 MHz
- in order to perform the sweep versus "y" an offset is applied to $f_0$ and to the local oscillator of the sampling convertor, in stead of changing the carrier frequency setting on the VSA.

The method according to the present invention allows the accurate characterization of the phase error of a VSA or the RF signal of any other device-under-test. The method is robust, uses readily available hardware and it can use all the instruments in a raw non-calibrated mode of operation, except for the reference clock which generates the 10 MHz frequency. This makes it a good candidate for a standard measurement procedure and for calibrating a VSA.

It will be appreciated that in the case of measuring the phase characteristics of a modulated RF signal of a device-under-test different from the VSA in the measurement set-up disclosed above, the VSA is being replaced by the device-under-test of which the RF signal is to be measured.

The invention is not limited to the specific embodiments and arrangement disclosed above. Those skilled in the art will appreciate that a number of modifications can be made for measuring a device-under-test without departing from the novel and inventive teachings of the present invention.

## Claims

1. Method for measuring phase characteristics of a modulated RF signal of a device-under-test, said method comprising the steps of:

subjecting said RF signal to a homodyne mixing process by applying a test signal having a predetermined frequency spectrum providing an IF output signal having first and second signal parts,
measuring frequency spectra of said test signal and said first and second IF output signal parts at a plurality of discrete frequencies, and
calculating said phase characteristics of said RF signal from said measured frequency spectra.

2.  Method according to claim 1, wherein said test signal is substantially down-converted to DC by said homodyne mixing process.

3.  Method according to claim 2, wherein said phase characteristics are calculated by a repeated recursively measurement at frequency intervals.

4.  Method according to any of the previous claims, wherein said test signal is generated having a discrete frequency spectrum.

5.  Method according to claim 4, wherein said frequency spectrum of said test signal is comprised of a plurality of equally spaced tones.

6.  Method according to claim 5, wherein said tones having a phase such that said test signal has a low crest-factor.

7.  Method according to claim 6, wherein said device-under-test is a Vector Signal Analyzer.

8.  Method for calibrating a Vector Signal Analyzer by measuring its phase error using the method according to any of the previous claims.

9.  Arrangement for measuring phase characteristics of a modulated RF signal of a device-under-test, said arrangement comprising homodyne mixing means, having an input for applying a test signal, an input for applying an RF signal of a device-under-test, and an IF output, means for measuring frequency spectra of said test signal and first and second signal parts of an IF output signal at said IF output of said homodyne mixing means at a plurality of discrete frequencies, and means for calculating said phase characteristics of said RF signal from said measured frequency spectra.

10. Arrangement according to claim 9, wherein said homodyne mixing means comprise a broadband sampling mixer and analog-to-digital conversion means.

11. Arrangement according to claim 9, wherein said device-under-test is a Vector Signal Analyzer.

S(f)

-a    0    +a    f
(scaled freq)

↑
carrier frequency

# Fig. 1

$S_{M-}(f)$

-a    0    +a    f
(scaled freq)

$S_{M+}(f)$

# Fig. 2

$S_V(y,f)$

-1    y-a    0    y    y+a    +1    f
(scaled freq)

VSA carrier frequency

VSA bandwidth limits

# Fig. 3

M(0, f)

## Fig. 4

$M_0(0, f)$ and fitted 20th degree polynomial

## Fig. 5

3D-plot of $M_0(y, f)$

## Fig. 6

3D-plot of $M_0(y, f)$ for a small range

## Fig. 7

E(f) determined by recursive splitting of intervals

## Fig. 8

Points in the (y, f)-plane used for the construction of E(f) on (-a, +a)

## Fig. 9

E(f) calculated on the whole interval (-1, +1)

## Fig. 10

Residual of $M_0(y, f)$, evaluated for all values of y and for f = 0.3

## Fig. 11

$M_0(y, f)$, evaluated for all values of y and for f = 0.3

## Fig. 12

Fig. 13

**European Patent Office**

**EUROPEAN SEARCH REPORT**

Application Number

EP 02 07 7183

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 2 813 250 A (TYSON OWEN A) 12 November 1957 (1957-11-12) * column 2, line 23 - line 54; figures 1,2 * | 1,9 | G01R25/00 G01R25/02 G01R31/28 |
| A | WO 01 84707 A (NOKIA NETWORKS OY ;NOKIA INC (US)) 8 November 2001 (2001-11-08) * the whole document * | 1,9 | |
| A | US 3 938 150 A (PHILLIPS CHESTER C ET AL) 10 February 1976 (1976-02-10) * column 2, line 1 - column 6, line 2; figures 1,2 * | 1,9 | |

TECHNICAL FIELDS SEARCHED (Int.Cl.7)

G01R

The present search report has been drawn up for all claims

| Place of search | Date of completion of the search | Examiner |
|---|---|---|
| THE HAGUE | 28 November 2002 | Heinsius, R |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 02 07 7183

This annex lists the patent family members relating to the patent documents cited in the above-mentioned European search report.
The members are as contained in the European Patent Office EDP file on
The European Patent Office is in no way liable for these particulars which are merely given for the purpose of information.

28-11-2002

| Patent document cited in search report | | Publication date | Patent family member(s) | | Publication date |
|---|---|---|---|---|---|
| US 2813250 | A | 12-11-1957 | NONE | | |
| WO 0184707 | A | 08-11-2001 | AU<br>WO | 4097001 A<br>0184707 A2 | 12-11-2001<br>08-11-2001 |
| US 3938150 | A | 10-02-1976 | NONE | | |

EPO FORM P0459